# EUROPÄISCHE PATENTSCHRIFT

(11) **EP 0 433 743 B1**
(45) Veröffentlichungstag und Bekanntmachung des Hinweises auf die Patenterteilung: **02.11.1995**
(21) Anmeldenummer: 90123081.3
(22) Anmeldetag: 03.12.1990
(51) Int. Cl.: H05K 9/00, H05K 5/00

(54) **Kunststoffgehäuse für elektronische Bauteile**
Plastic casing for electronic components
Boîtier en matière plastique pour des composants électroniques

(30) Priorität: 18.12.1989 DE 3941680
(43) Veröffentlichungstag der Anmeldung: 26.06.1991
(73) Patentinhaber: TEMIC TELEFUNKEN microelectronic GmbH, 74072 Heilbronn (DE)
(72) Erfinder: Schöberl, Werner, W-7101 Massenbachhausen (DE)
(74) Vertreter: Maute, Hans-Jürgen, Dipl.-Ing.

(56) Entgegenhaltungen:
- EP-A- 0 323 644
- DE-B- 2 221 786
- JP-A-63 286 437
- US-A- 4 596 670

## Beschreibung

Elektronische Bauelemente, Baugruppen oder Schaltungen, die als diskrete Bauteile auf einem Trägersubstrat, beispielsweise auf einer Schaltungsplatine, angeordnet sind, müssen zum Schutz gegen Umwelteinflüsse, beispielsweise externe elektrische Störungen, mit einem Abschirmgehäuse versehen werden; ein solches wird auch dann benötigt, wenn die Schaltungskomponenten eingegossen sind. Siehe z.B das Dokument DE-B-2 221 786. Üblicherweise werden dazu Blechgehäuse eingesetzt, die die Schaltungsplatine bzw. die Vergußmasse umschließen.

Der Erfindung liegt die Aufgabe zugrunde, Blechgehäuse als Abschirmgehäuse zu ersetzen. Dies wird bei einem Kunststoffgehäuse mit einer Fotodiodenschaltung gemäß Anspruch 1 erreicht. Dabei besteht der Kunststoff zur Abschirmung aus einem elektrisch leitfähigen Material.

Das Kunststoffgehäuse kann als Abschirmgehäuse geometrisch günstiger und flexibler als die üblichen Blechgehäuse ausgeformt werden; da Kunststoff dichter als Blech ist, wird zudem der Schutz der Bauteile bzw. der Schaltung gegenüber Umwelteinflüssen verbessert. Bei vergossenen Bauelementen kann die thermische Spannung reduziert und dadurch die Zuverlässigkeit der Bauteile bzw. der Schaltung erhöht werden, weil der thermische Ausdehnungskoeffizient des Kunststoffgehäuses in etwa dem Ausdehnungskoeffizienten der Vergußmasse entspricht, was bei Blechgehäusen nicht der Fall ist.

Des weiteren können, beispielsweise durch die Formgebung des Kunststoffgehäuses oder durch Variation des Kunststoffmaterials, Eigenschaften der Bauteile oder der Schaltung gezielt beeinflußt werden.

Als Kunststoffmaterial wird vorzugsweise Polyimid verwendet, als Füllstoff dienen Kohlefasern; die Leitfähigkeit liegt bei ca. 0,5 - 3 kΩ pro Flächeneinheit. Es sind beliebige Versionen der Gehäuseform möglich; vorzugsweise werden flache quaderförmige Gehäuse je nach Erfordernis der externen Schaltung eingesetzt, wobei die Anschlußstifte des Trägersubstrats aus einer Ebene herausgeführt sind. Das Gehäuse kann dadurch ohne Abwinkelung der Anschlußstifte wahlweise um 90° versetzt in externe Schaltungen eingebaut werden.
Die Kontaktierung des Kunststoffgehäuses (Masseverbindung) kann durch Vernieten (Klemmen) des Gehäuseinneren mit der Masse der Schaltungsplatine erfolgen. Alternativ dazu können in geeigneten Bohrungen im Gehäuse Stifte eingepreßt werden, die die Masseverbindung zur Masse peripherer bzw. externer Schaltungen vornehmen; dies erlaubt es, die Abschirmung ggf. auf eine vom Signalpegel unabhängige Masse zu legen.

Die Herstellung des Kunststoffgehäuses erfolgt vorzugsweise mittels Spritzgußtechnik, wobei das Kunststoffmaterial in die gewünschte Gehäuseform eingepreßt wird.

Die Erfindung und ihre Ausgestaltung soll nachstehend anhand des Ausführungsbeispiels eines Fotodiodengehäuses beschrieben werden.

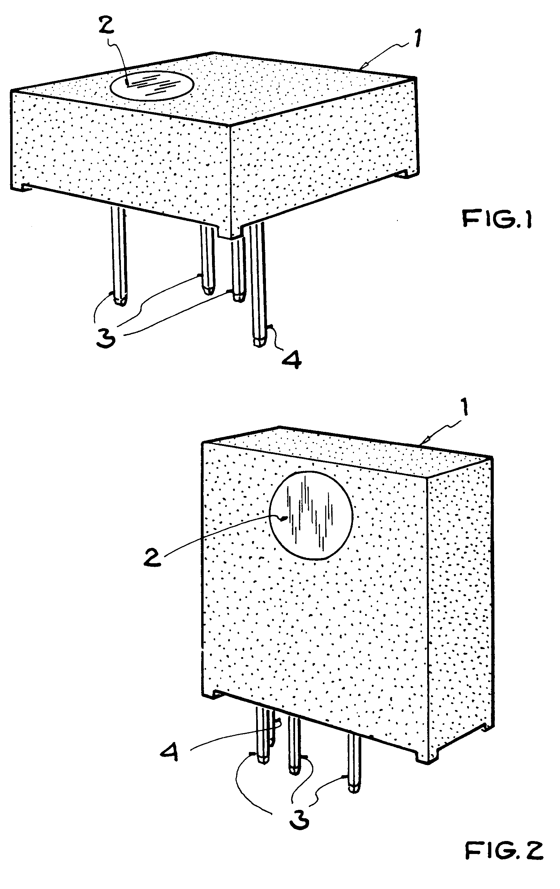

In den Figuren 1 und 2 werden zwei Gehäuseformen dargestellt, die einen um 90° versetzten Einbau in eine externe Schaltungsplatine erlauben, wobei in der Fig. 1 das Gehäuse in "liegender Form" und in der Fig. 2 das Gehäuse in "stehender Form" dargestellt ist. Dies bedeutet, daß beim Gehäuse der Fig. 1 die Anschlußstifte senkrecht und beim Gehäuse der Fig. 2 parallel zur Schaltungsplatine bzw. zur Hauptausdehnungsrichtung des Gehäuses angeordnet sind.

Der Kunststoff-Gehäusebecher 1 wird in der gewünschten Bauform, beispielsweise mittels eines Spritzgußverfahrens, ausgeformt. In der Ausführungsform der Fig. 1 besitzt das quaderförmige, "liegende" Gehäuse beispielsweise die Abmessungen 20 mm x 20 mm x 6 mm; das "stehende" Gehäuse der Fig. 2 besitzt beispielsweise die Abmessungen 18 mm x 7 mm x 21 mm.
Der Gehäusebecher besteht aus elektrisch leitfähigem Kunststoff, beispielsweise Polyimid. In den Kunststoff ist in einer geeigneten Bohrung ein Kontaktstift 4 eingepreßt, der zur Masseverbindung des Gehäuses dient, indem er beispielsweise mit der Masse einer externen Schaltung, in die das Gehäuse eingebaut wird, verlötet wird.
Die Lichteintrittsöffnung 2, mit einer Fläche von beispielsweise 5 mm², ist vorwiegend rund ausgeführt und zur Vergrößerung des Öffnungswinkels an ihrem Rand konisch, sich nach innen verjüngend ausgeformt. Eine Kerbe in der Lichteintrittsöffnung 2 dient der Entlüftung beim späteren Ausgießen, um Luftblasen in der Lichteintrittsöffnung zu vermeiden.
Des weiteren kann auf die Lichteintrittsöffnung 2 eine transparente Schicht aus einem anderen Kunststoffmaterial aufgebracht werden, die als "Linse " zur Verbesserung der Strahlungseinkopplung dient. Das Kunststoffmaterial des Gehäusebechers enthält spezielle Pigmente, durch die eine Filterwirkung erzielt werden kann.

Die Fotodioden-Schaltungsplatine, von der in den Fig. 1 und 2 nur die externen Anschlußstifte 3 sichtbar sind, wird in den Becher 1 eingebracht, der mit einem transparenten Gießharz ausgegossen wird. Die Fotodiodenseite der Schaltung wird mit transparentem Epoxidharz, vergossen; der restliche Teil der Schaltung wird zum mechanischen Schutz und zum Schutz gegen Feuchtigkeit mit einem zykelbeständigen Gießharz gefüllt, der nicht unbedingt transparent sein muß.

Um die Temperaturzykel-Eigenschaft zu verbessern, werden zur Verankerung der Vorder- und Rückseitenfüllung soweit als möglich größere Durchgangslöcher in die Schaltungsplatine eingebracht.
Um ein höheres Signal-Rausch-Verhältnis zu erreichen bzw. um die Reichweite der Fotodiode zu erhöhen, wird dem Gießharz der Fotodiodenseite ein Filterpigmentstoff beigemischt, der eine Filtercharakteristik hervorruft. Damit beispielsweise das Umgebungslicht (Glühlampen, Sonnenlicht ...) weggefiltert wird, besitzt das Filterpigment IR-Filtereigenschaften, indem es bei einer maximalen Empfindlichkeit bei 950 nm als Kantenfilter Strahlung erst ab ca. 850 nm durchläßt.

Derartige optoelektronische Schaltkreise können beispielsweise in Fernsteuerungen etc. Verwendung finden. Eine prinzipielle Anwendungsmöglichkeit der Erfindung besteht jedoch bei allen elektronischen Bauteilen, Baugruppen oder Schaltungen, die beispielsweise auf Trägersubstraten oder Schaltungsplatinen aufgebracht sind und abgeschirmt werden müssen.

## Patentansprüche

1. Gehäuse mit einer Fotodiodenschaltung für eine Fotodiode, mit den Merkmalen:
a) das Gehäuse (1) ist als Kunststoffgehäuse aus einem elektrisch leitfähigen Material ausgebildet,
b) das Kunststoffgehäuse (1) weist eine Lichteintrittsöffnung (2) auf, die an ihrem Rand konisch, sich nach innen verjüngend ausgeformt ist und von einer Kunststoffschicht bedeckt ist,
c) die auf einer Schaltungsplatine angebrachte Fotodiodenschaltung ist im Kunststoffgehäuse (1) vergossen, wobei Anschlußstifte (3) der Schaltungsplatine auf der Unterseite des Kunststoffgehäuses (1) zum Einbau des Kunststoffgehäuses (1) in eine periphere Schaltung überstehen,
d) dem Material des Kunststoffgehäuses (1) sind Farbpigmente mit Filtereigenschaften beigemischt,
e) die Vergußmasse für die Fotodiodenschaltung besitzt IR-Filtereigenschaften.

2. Gehäuse nach Anspruch 1, wobei als Material des Kunststoffgehäuses (1) Polyimid verwendet wird, dem als Füllstoff Kohlefasern beigemengt sind.

3. Gehäuse nach Anspruch 1 oder 2, wobei das Gehäuse (1) die Form eines flachen Quaders besitzt, dessen Hauptfläche parallel zur Fläche der Schaltungsplatine verläuft.

4. Gehäuse nach einem der Ansprüche 1 bis 3, wobei die Anschlußstifte (3) der Schaltungsplatine derart aus einer Ebene herausgeführt sind, daß das Gehäuse (1) ohne Abwinkeln der Abschlußstifte (3) in eine externe Schaltung einbaubar ist.

5. Gehäuse nach einem der Ansprüche 1 bis 4, wobei der Masseanschluß des Gehäuses (1) durch in Bohrungen des Gehäuses (1) angebrachte Stifte (4) zur Masse peripherer Schaltungen erfolgt.

6. Kunststoffgehäuse nacn einem der Ansprüche 1 bis 4, wobei der Masseanschluß des Gehäuses (1) durch Vernieten im Inneren des Gehäuses (1) zur Masse der Schaltungsplatine erfolgt.

## Claims

1. A housing with a photo-diode circuit for a photo-diode having the features:
a) the housing (1) has the form of a plastics housing composed of an electrically conductive material,
b) the plastics housing (1) possesses a light inlet opening (2) which at its edge is shaped in a conical formation tapering inwards and which is covered with a plastics coating,
c) the photo-diode circuit applied to a circuit board is cast in the plastics housing (1), where terminal pins (3) of the circuit board project from the underneath of the plastics housing (1) for the installation of the plastics housing (1) in a peripheral circuit,
d) colouring pigments with filter properties are admixed to the material of the plastics housing (1),
e) the casting compound for the photo-diode circuit possesses IR filter properties.

2. A housing as claimed in Claim 1, where polyimide, to which carbon fibres have been added by way of filler, is used as material of the plastics housing (1).

3. A housing as claimed in Claim 1 or 2, where the housing (1) has the form of a flat parallelepiped, the main surface of which extends in parallel to the surface of the circuit board.

4. A housing as claimed in one of Claims 1 to 3, where the terminal pins (3) of the circuit board project from a plane in such manner that the housing (1) can be installed into an external circuit without bending of the terminal pins (3).

5. A housing as claimed in one of Claims 1 to 4, where the earth connection of the housing (1) is established by pins (4), arranged in bores of the housing (1), to the earth of peripheral circuits.

6. A plastics housing as claimed in one of Claims 1 to 4, where the earth connection of the housing (1) is established by riveting inside the housing (1) to the earth of the circuit board.

## Revendications

1. Boîtier contenant un circuit de photodiode pour une photodiode, ayant les particularités suivantes:
a) le boîtier (1) est réalisé comme un boîtier en matière plastique d'un matériau électriquement conducteur,
b) le boîtier en matière plastique (1) présente une ouverture d'entrée de la lumière (2) conformée coniquement à son bord, en se rétrécissant vers l'intérieur, et recouverte d'une couche de matière plastique,
c) le circuit de photodiode, disposé sur une plaquette de circuit imprimé ou analogue, est encapsulé dans le boîtier de matière plastique (1), des broches de connexion (3) de la plaquette dépassant du côté inférieur du boîtier (1) en vue de l'incorporation de celui-ci dans un circuit périphérique,
d) des pigments colorés ayant des propriétés filtrantes sont ajoutés en mélange au matériau du boîtier en matière plastique (1) et
e) la masse d'encapsulage du circuit de photodiode possède des propriétés de filtrage des rayons infrarouges.

2. Boîtier selon la revendication 1, utilisant comme matériau du boîtier en matière plastique (1) un polyimide auquel des fibres de carbone ont été ajoutées en mélange en tant que charge.

3. Boîtier (1) selon la revendication 1 ou 2 ayant la forme d'un parallélépipède plat dont les grandes faces sont parallèles à la surface de la plaquette de circuit.

4. Boîtier selon une des revendications 1 à 3 dont les broches de connexion (3) de la plaquette de circuit sont sorties de telle manière d'un plan que le boîtier (1) peut être incorporé dans un circuit externe sans coudage des broches de connexion (3).

5. Boîtier (1) selon les revendications 1 à 4 dont la connexion de la masse est réalisée par des broches (4) mises en place dans des perçages du boîtier (1) et reliées à la masse de circuits périphériques.

6. Boîtier en matière plastique (1) selon une des revendications 1 à 4, dont la connexion à la masse de la plaquette de circuit est réalisée par rivetage à l'intérieur du boîtier (1).
